Europäisches Patentamt

**European Patent Office**

Office européen des brevets

(19)

(11) Numéro de publication: **0 141 124**
**B2**

(12) NOUVEAU FASCICULE DE BREVET EUROPEEN

(45) Date de publication du nouveau fascicule du brevet: **08.08.90**

(51) Int. Cl.⁵: **H 01 L 39/14**

(21) Numéro de dépôt: **84110210.6**

(22) Date de dépôt: **28.08.84**

(54) **Brins supraconducteurs utilisable aux fréquence industrielles.**

(30) Priorité: **30.08.83 FR 8313916**

(43) Date de publication de la demande:
**15.05.85 Bulletin 85/20**

(45) Mention de la délivrance du brevet:
**14.10.87 Bulletin 87/42**

(45) Mention de la decision concernant l'opposition:
**08.08.90 Bulletin 90/32**

(84) Etats contractants désignés:
**CH DE FR GB IT LI NL**

(56) Documents cités:
**EP-A-0 119 553**
**DE-A-2 525 980**
**US-A-3 618 205**

(73) Titulaire: **ALSTHOM**
**38, avenue Kléber**
**F-75784 Paris Cédex 16 (FR)**

(72) Inventeur: **Fevrier, Alain**
**25, avenue de Parisis**
**F-78310 Maurepas (FR)**
Inventeur: **Dubots, Patrick**
**1, chemin de Gaillarbois**
**F-78640 Neuaphle Le Chateau (FR)**
Inventeur: **Hoang, Gia Ky**
**9, Domaine de l'Etang Cravanche**
**F-90300 Valdoie (FR)**

(74) Mandataire: **Weinmiller, Jürgen et al**
**Lennéstrasse 9 Postfach 24**
**D-8133 Feldafing (DE)**

EP 0 141 124 B2

Courier Press, Leamington Spa, England.

# Description

La présente invention concerne des structures de brins multifilamentaires supraconducteurs pouvant garder l'état supraconducteur jusqu'à des variations d'induction magnétique de 1000 Teslas par seconde et par conséquent utilisables aux fréquences industrielles.

Les brins supraconducteurs sont en général constitués de filaments supraconducteurs réunis au sein d'une matrice stabilisatrice métallique non supraconductrice qui évacue la chaleur dégagée et constitue un shunt électrique pour les régions des filaments supraconducteurs ayant perdu leur état supraconducteur en raison d'une augmentation locale de température. Le brevet français n° 2 005 492 donne des exemples de brins supraconducteurs constitués de filaments supraconducteurs en alliage de niobium titane noyés dans une matrice en cupronickel.

De tels brins supraconducteurs sont soumis en régime d'induction magnétique lentement variable à des instabilités obligeant à les utiliser à des densités de courant très inférieures à celles qu'ils devraient théoriquement supporter. Pour améliorer leur comportement, on a proposé de diminuer les pertes en régime variable des brins supraconducteurs en diminuant l'épaisseur de leurs filaments supraconducteurs jusqu'à des valeurs de l'ordre de 10 à 50 μm et en torsadant ces derniers, et d'améliorer l'efficacité de la matrice stabilisatrice en la réalisant à l'aide de deux composants, l'un procurant à la matrice une grande résistivité transversale pour s'opposer à la circulation des courants d'aimantation entre filaments et l'autre procurant de grandes conductibilités thermique et électrique longitudinales pour une évacuation efficace de la chaleur et un bon shuntage des régions des filaments ayant perdu leur état supraconducteur. Le brevet français précité donne des exemples de structures de brin supraconducteur pouvant supporter des variations d'induction magnétique de l'ordre de 0,1 à 10 Teslas par seconde dans lesquelles les filaments supraconducteurs sont soit gainés individuellement d'une couche d'alliage de cupronickel à haute résistivité puis noyés dans une matrice de cuivre pur à bonne conductivité, soit noyés dans une matrice d'un alliage de cupronickel à haute résistivité entourée d'une gaine de cuivre massif. Ces brins d'un diamètre de l'ordre de 0,25 mm sont enduits d'un vernis isolant puis câblés entre eux pour constituer un câble supraconducteur pouvant transporter des courants significatifs.

Ces brins supraconducteurs bien que d'un comportement amélioré sont loin de supporter les variations d'induction magnétique rencontrées dans les utilisations aux fréquences industrielles.

La fabrication de conducteurs supraconducteurs pouvant fonctionner aux fréquences industrielles en particulier à 50—60Hz, et/ou pouvant supporter de très rapides variations d'induction de l'ordre de 1000 Teslas par seconde et au dessus nécessite de spécifier des structures à filaments supraconducteurs noyés dans une matrice stabilisatrice ayant une très bonne stabilité magnétique et des pertes très réduites.

La stabilité magnétique est obtenue, de manière connue, en meénageant dans la matrice stabilisatrice une zone contenant un métal normal à forte conductivité électrique et thermique qui assure également la protection du brin en cas de transition à l'état normal lorsqu'il est utilisé dans un bobinage.

Pour réduire les pertes, on est conduit a utiliser les solutions connues: diminuer le diamètre des filaments supraconducteurs ce qui diminue les pertes par hystérésis et torsader ou transposer les filaments supraconducteurs ce qui diminue les courants induits circulant entre les filaments et par conséquent les pertes qu'ils occasionnent dans la matrice stabilisatrice.

En plus de ces mesures on fractionne le métal normal de la zone assurant la stabilité magnétique et la protection des brins en cas de transition à l'état normal en un ensemble de filaments longitudinaux au moyen d'un cloisonnement en un alliage fortement résistif ce qui diminue les courants induits dans cette zone.

Le pas de torsade des filaments supraconducteurs est plus ou moins lié au diamètre du brin par les conditions de fabrication et sa réduction implique celle du diamètre du brin. On est donc conduit, pour obtenir un faible pas de torsade à réaliser des brins de très faible diamètre qui doivent être isolés et câblés ensemble pour constituer un conducteur ayant une capacité de transport de courant significative. Il importe alors que l'isolation entre brins ne réduise pas la densité de courant hors tout transporté par le conducteur.

La présente invention a pour but de réaliser des brins supraconducteurs avec une isolation d'épaisseur moindre que celle d'une couche isolante classique en vernis émaillé.

Elle a pour objet un brin supraconducteur comportant une première zone, multifilamentaire avec des filaments supraconducteurs noyés dans une matrice stabilisatrice en alliage à haute sensitivité, une deuxième zone, de haute conductivité électrique et thermique longitudinale constituée d'au moins un conducteur à haute conductivité électrique fractionné en filaments par un cloisonnement fortement résistif, et une troisième zone formée d'une gaine isolante en poudre entourée extérieurement d'une enveloppe métallique fortement résistive, la première zone étant située au centre du brin et le deuxième zone étant placée autour de la première, ou vice-versa.

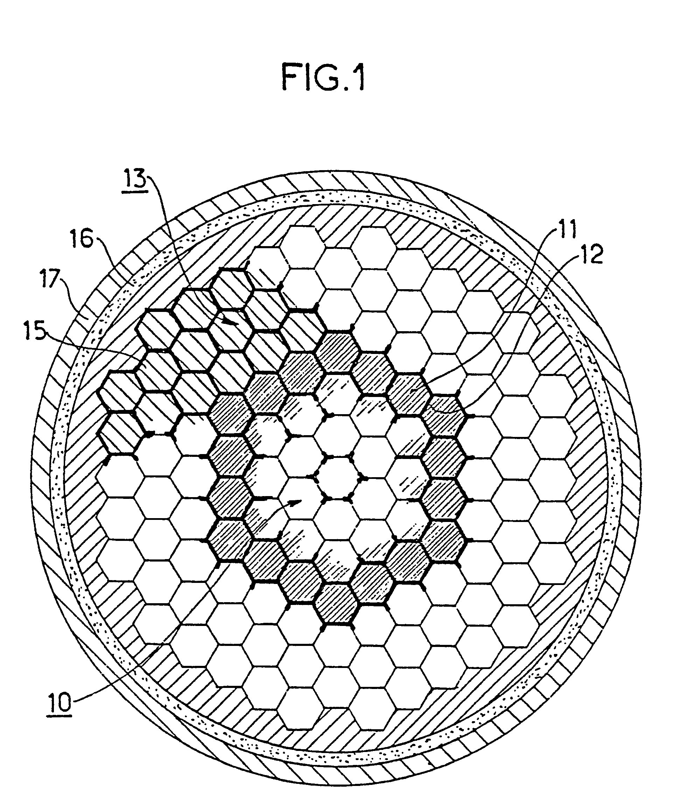

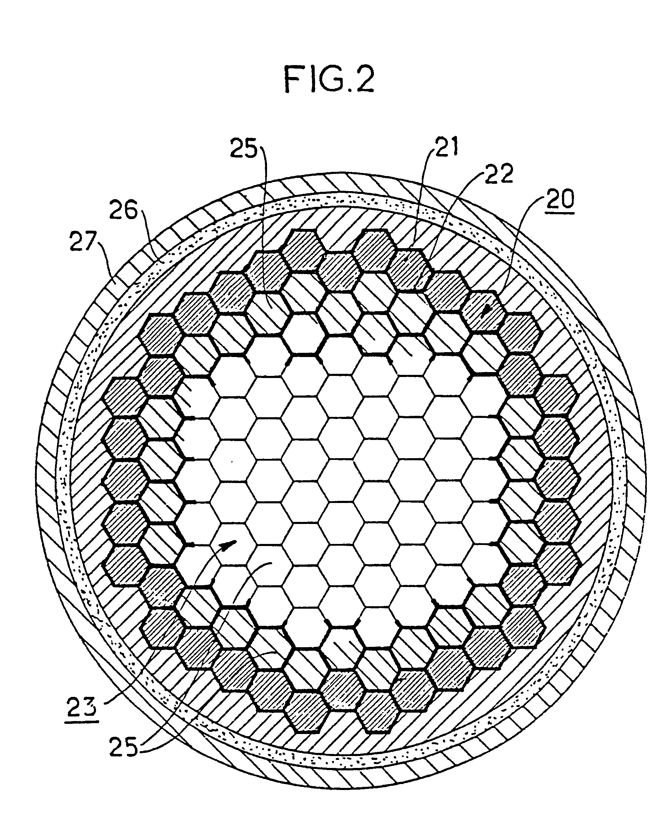

D'autres caractéristiques et avantages de plusieurs modes de réalisation de l'invention ressortiront de la description ci-après. Cette description sera faite en regard du dessin dans lequel les figures 1 et 2 représentent des vues en coupe de brins supraconducteurs selon l'invention.

La figure 1 illustre une structure de brin supraconducteur selon l'invention. Cette structure comporte les trois zones suivantes:

— une zone centrale non supraconductrice 10 à hautes conductibilités électrique et thermique longitudinales et à haute résistivité transversale constituée par un conducteur de cuivre pur fractionné en 37 filaments 11 de section hexagonale par un cloisonnement 12 en alliage de cupronickel,

— une zone multifilamentaire 13 concentrique formée de 1 229 844 filaments supraconducteurs séparés entre eux par des cloisons en alliage de cupronickel et répartis autour de la zone centrale en 84 paquets 15 de section hexagonale de même dimension que les filaments 11 de cuivre de la zone centrale, chaque paquet 15 résultant lui même de l'assemblage de 121 groupes à section hexagonale de 121 filaments supraconducteurs gainés d'un alliage de cupronickel.

— et une zone externe concentrique formée d'une couronne isolante en poudre d'oxyde 16 et d'une couronne externe en alliage de cupronickel 17.

A titre indicatif, les différents filaments supraconducteurs peuvent être en un alliage de niobium titane à 46% de titane et les différents alliages de cupronickel à 30% de nickel. Le cuivre utilisé est avantageusement un cuivre a haute conductivité, exempt d'oxygène.

Cette structure peut être obtenue de la manière suivante:

Au cours d'une première étape, on réalise un "étage 0" constitué d'un lopin de niobium titane par exemple de 60 mm de diamètre introduit dans un tube de cupronickel de diamètre intérieur légèrement plus grand et d'une épaisseur de 30 mm. Afin de faciliter la fabrication des filaments très fins, une feuille ou un tube de niobium de quelques dixièmes de millimètres d'épaisseur est inséré entre le tube et le lopin. L'ensemble est mis sous vide et fermé hermétiquement puis filé à une température comprise entre 500 et 650°C et étiré à froid pour être amené par passes successives à une cote hexagonale de l'ordre de 10 mm.

Au cours d'une deuxième étape, on réalise un "étage 1" constitué d'un assemblage de 121 tiges hexagonales de l'étage 0 que l'on introduit dans un tube de cupronickel à ses dimensions. Les vides le long de la paroi interne du tube sont complés par des tiges de cupronickel puis l'ensemble est mis sous vide, fermé hermétiquement, filé à une température comprise entre 500° et 650°C et étiré à froid pour être amené par passes successives à une cote hexagonale de l'ordre de 10 mm. On obtient ainsi une tige constituée d'un assemblage de 121 filaments de niobium titane noyés dans une matrice de cupronickel.

Au cours d'une troisième étape on réalise un "étage 2" en répétant les mêmes opérations que pendant l'étape précédente mais à partir des tiges hexagonales de l'étape 1. On réalise ainsi une tige à cote hexagonale de l'ordre de 10 mm renfermant 14641 filaments de niobium titane gainés de cupronickel d'où sont tirés les paquets de filaments supraconducteurs 3 de la structure finale du brin représenté dans la figure 1.

Au cours d'une quatrième étape on réalise un "étage 2'''" constitué d'un lopin de cuivre pur par exemple de 60 mm de diamètre introduit dans un tube de cupronickel d'un diamètre intérieur légèremeent supérieur et d'une épaisseur de 15 mm. L'ensemble est ensuite mis sous vide, fermé hermétiquement, filé à une température comprise entre 500 et 650°C et étiré à froid pour être amené par passes successives à une cote hexagonale de l'ordre de 10 mm.

Au cours d'une cinquième étape on réalise un "étage 3" constitué d'un assemblage de 121 tiges hexagonales introduites dans un tube de cupronickel. 37 de ces tiges sont en cuivre revêtu de cupronickel, issues de l'étage 2' et rassemblées en un noyau central. Les 84 tiges restantes sont constituées de filaments de niobium titane gainés de cupronickel, issues de l'étage 2 et disposées à la périphérie des précédentes.

Les vides entre le tube de cupronickel et l'assemblage de tiges sont comblés par des tiges de cupronickel. L'ensemble est ensuite mis sous vide, fermé hermétiquement puis filé à une température de l'ordre de 500 à 650°C.

Au cours d'une sixième étape, la barre filée issue de l'étage 3 est recouverte d'un tube réalisé par compactage de poudre d'oxyde métallique par exemple un oxyde de magnésium ou d'aluminium éventuellement dopé de cuivre ou d'un alliage de cuivre tel que le bronze ou le cupronickel et d'un tube de cupronickel. Le tout est ensuite coétiré par passes successives jusqu'à obtenir un brin de diamètre inférieur au millimètre par exemple 0.8 mm. L'isolation du brin est assurée par une couche très mince, de l'ordre de quelques microns d'épaisseur, ce qui permet, lors de la réalisation de conducteurs comportant jusqu'à plusieurs centaines de brins, de maintenir une densité de courant globale élevée.

Les filaments supraconducteurs ont alors un diamètre de l'ordre de 0,35 µm et ceux de cuivre un diamètre de l'ordre de 0,06 mm.

Au cours de la fabrication du brin on réalise plusieurs traitements thermiques afin que ce dernier présente une haute densité de courant critique.

La figure 2 représente une structure de brin supraconducteur qui se différence de celle de la figure 1 par le fait que la zone multifilamentaire 23 composée de 85 paquets 25 à section hexagonale de filaments supraconducteurs séparés entre eux par du cupronickel est placée au centre du brin tandis que la zone non supraconductrice 20 à hautes conductibilités thermique et électrique est placée autour de la zone multifilamentaire avec 36 filaments de cuivre 21 isolé au cupronickel 22 et à section hexagonale disposés côte à côte selon une couronne. Comme dans le cas précédent le tout est entouré d'une couronne isolante en poudre d'oxyde 26 et d'une gaine extérieure en cupronickel 27.

Cette structure se fabrique de la même manière que la précédente en modifiant au cours de la cinquième étape la disposition des tiges hexagonales en cuivre revêtu du cupronickel par rapport aux tiges hexagonales multifilamentaires pour obtenir la configuration désirée.

On peut notamment remplacer le niobium- titane par le niobium-étain. La fabrication du brin diffère alors du procédé exposé ci-dessus sur les points suivants:

— au cours de la première étape, "l'étage 0" est constitué d'un lopin de niobium introduit dans une matrice de bronze; la teneur en étain du bronze Cu-Sn est la plus proche possible de la limite de solubilité de l'étain dans le cuivre.

— au cours des deuxième, troisième et cinquième étapes, le cupronickel est remplacé par l'alliage de bronze.

— au cours de la quatrième étape, le "étage 2" est constitué d'un lopin de cuivre pur introduit dans un tube de bronze. Afin de préserver la bonne conductibilité électrique du cuivre pur, une feuille ou un tube de tantale est inséré entre le lopin et le tube.

— au cours d'une septième étape, le brin subit un traitement plusieurs heures à plusieurs dizaines d'heures pour former la phase supraconductrice $Nb_3Sn$.

Les brins ainsi réalisés, pouvant supporter des variations d'induction magnétique jusqu'à 1000 Tesla/seconde, ouvrent de nouvelles perspectives d'applications industrielles des brins supraconducteurs: stator d'alternateur, moteurs, transformateurs . . . etc.

## Revendications

1. Brin supraconducteur comportant une première zone, multifilamentaire (13) avec des filaments supraconducteurs noyés dans une matrice stabilisatrice en alliage à haute sensitivité, une deuxième zone, de haute conductivité électrique et thermique (10) longitudinale constituée d'au moins un conducteur à haute conductivité électrique fractionné en filaments (11) par un cloisonnement fortement résistif (12), et un troisième zone formée d'une gaine isolante (16, 26) en poudre entourée extérieurement d'une enveloppe métallique fortement résistive (17, 27), la première zone étant située au centre du brin et le deuxième zone étant placée autour de la première, ou vice-versa.

2. Brin supraconducteur selon la revendication 1, caractérisé en ce que ladite gaine isolante en poudre (16, 26) est en poudre d'oxyde de magnésium MgO ou d'aluminium $Al_2O_3$.

3. Brin supraconducteur selon la revendication 1, caractérisé en ce que ladite gaine isolante en poudre (16, 26) est en poudre d'oxyde de magnésium MgO dopé de cuivre ou d'un alliage de cuivre tel que le bronze ou le cupronickel.

4. Brin supraconducteur selon la revendication 1, caractérisé en ce que l'enveloppe métallique (17, 27) entourant extérieurement la gaine isolante en poudre est en alliage de cupronickel.

## Patentansprüche

1. Supraleitende Litze mit einem ersten vieladrigen Bereich (13) mit in eine stabilisierende Matrix aus einer Legierung hohen spezifischen Widerstands eingebetteten supraleitenden Adern, mit einem zweiten Bereich hoher elektrischer und thermischer Leitfähigkeit (10) in Längsrichtung, der aus mindestens einem Leiter hoher elektrischer Leitfähigkeit besteht, der durch eine Zwischenwand (12) hohen spezifischen Widerstands in Adern (11) aufgeteilt ist, und mit einem dritten Bereich, der von einer pulverförmigen isolierenden Hülle (16, 26) gebildet wird, die außen von einer Metallumhüllung hohen spezifischen Widerstands (17, 27) umgeben ist, wobei der erste Bereich sich in der Mitte der Litze und der zweite Bereich sich um diesen ersten Bereich herum befindet, oder umgekehrt.

2. Supraleitende Litze nach Anspruch 1, dadurch gekennzeichnet, daß die pulverförmige isolierende Hülle (16, 26) aus Magnesiumoxidpulver MgO oder aus Aluminiumoxidpulver $Al_2O_3$ besteht.

3. Supraleitende Litze nach Anspruch 1, dadurch gekennzeichnet, daß die isolierende pulverförmige Hülle (16, 26) aus mit Kupfer oder einer Kupferlegierung wie Bronze oder Kupfernickel dotiertem Magnesiumoxidpulver MgO besteht.

4. Supraleitende Litze nach Anspruch 1, dadurch gekennzeichnet, daß die Metallumhüllung (17, 27), die die pulverförmige Hülle außen umgibt, aus einer Kupfer-Nickellegierung besteht.

## Claims

1. A superconducting fibre comprising a multifilament area (13) with superconducting filaments embedded in a stabilizing matrix of high resistivity alloy, a second area of high longitudinal electrical and thermal conductivity (10) consisting of at least one conductor having a high electrical conductivity, this conductor being divided into filaments (11) by means of a highly resistive partitioning (12), and a third area formed by an insulating powder sheath (16, 26) surrounded by an outer metal envelope (17, 27) having a high resistivity, the first area being situated at the centre of the fibre and the second area being placed around the first one, or vice-versa.

2. A superconducting fibre according to claim 1, characterized in that said insulating powder sheath (16, 26) is made from magnesium oxide MgO powder or aluminium oxide $Al_2O_3$ powder.

3. A superconducting fibre according to claim 1, characterized in that said insulating powder sheath (16, 26) is made from magnesium oxide MgO powder doped with copper or with a copper alloy such as bronze or cupronickel.

4. A superconducting fibre according to claim 1, characterized in that the metal envelope (17, 27) surrounding the outside of the powder insulating sheath is made of cupronickel.

# FIG.1

# FIG.2